# EUROPEAN PATENT APPLICATION

(11) **EP 3 604 246 A1**
(43) Date of publication of application: **05.02.2020**
(21) Application number: 18774863.7
(22) Date of filing: 27.03.2018
(51) Int. Cl.: C03C 27/12, G01J 1/02, C09K 11/06

(54) **LASER LIGHT DETECTION TOOL**

(30) Priority: 29.03.2017 JP 2017066002
(71) Applicant: Sekisui Chemical Co., Ltd., Osaka-shi, Osaka 530-0047 (JP)
(72) Inventor: OOTA, Yuusuke, Koka-shi Shiga 528-8585 (JP); IZU, Yasuyuki, Roermond 6045 JB (NL); NAKAJIMA, Daisuke, Koka-shi Shiga 528-8585 (JP)
(74) Representative: Cabinet Beau de Loménie
(86) International application number: PCT/JP2018/012456
(87) International publication number: WO 2018/181328

(57) **Abstract**

The present invention aims to provide a laser light detecting device capable of easily detecting laser light irradiation. Provided is a laser light detecting device capable of detecting laser light irradiation, including: a luminescent sheet containing a thermoplastic resin and a luminescent material that is to be excited by laser light to emit visible light.

## Description

### TECHNICAL FIELD

The present invention relates to a laser light detecting device capable of easily detecting laser light irradiation.

### BACKGROUND ART

Laser pointers are used in presentation or education as tools to indicate one point on printed or drawn diagrams, images displayed by projectors, and the like. With advances in semiconductor lasers, ultra-high power laser pointers have recently been cheaply supplied and used in a wide range of fields (for example, Patent Literature 1).

The widespread use of laser, however, has increased incidents in which laser light from a laser pointer is aimed at the driver of a vehicle such as an automobile, a bike, or an airplane. The laser light entering the eye is very dangerous because it may cause driving mistakes leading to accidents. In addition, it also may cause loss of eyesight.

Most laser pointers emit visible light such as red or green light, but laser pointers emitting ultraviolet light or infrared light, which is invisible to the human eye, are also commercially available. In the case of irradiation with such non-visible laser light, the driver may cause an accident or lose their eyesight without even noticing the irradiation. Even irradiation with visible laser light is hard to notice unless the laser light directly enters the eye.

Patent Literature 2 discloses a laser irradiation detecting apparatus capable of providing effective means of defense against laser guided missiles. However, it is a significantly expensive, large apparatus for military purposes, and thus impossible to apply to common uses.

### CITATION LIST

### - Patent Literature

Patent Literature 1: JP 2015-079141 A
Patent Literature 2: JP H05-226728 A

### SUMMARY OF INVENTION

### - Technical problem

In view of the situation in the art, the present invention aims to provide a laser light detecting device capable of easily detecting laser light irradiation.

### - Solution to problem

The present invention relates to a laser light detecting device capable of detecting laser light irradiation, including a luminescent sheet containing a thermoplastic resin and a luminescent material that is to be excited by laser light to emit visible light.

The present invention is described in detail below.

The inventors made intensive studies to find out that upon laser light irradiation of a luminescent sheet containing a thermoplastic resin and a luminescent material that is to be excited by laser light to emit visible light, the luminescent material emits visible light, allowing easy detection of even non-visible laser light, that is, ultraviolet laser light or infrared laser light. The inventors thus completed the present invention.

The laser light detecting device of the present invention includes a luminescent sheet containing a thermoplastic resin and a luminescent material.

Any thermoplastic resin may be used, and examples thereof include polyvinyl acetal resins, ethylene-vinyl acetate copolymer resins, ethylene-acryl copolymer resins, polyurethane resins, polyurethane resins containing sulfur element, polyvinyl alcohol resins, vinyl chloride resins, and polyethylene terephthalate resins. Suitable among these are polyvinyl acetal resins because a polyvinyl acetal resin used in combination with a plasticizer can exhibit excellent adhesion to a transparent plate in the case where the luminescent sheet and a transparent plate such as a glass plate are stacked together.

The polyvinyl acetal resin is not particularly limited as long as it is obtained by acetalization of polyvinyl alcohol with an aldehyde, and is preferably polyvinyl butyral. Two or more kinds of polyvinyl acetal resins may be used in combination as needed.

The lower limit of the degree of acetalization of the polyvinyl acetal resin is preferably 40 mol% and the upper limit thereof is preferably 85 mol%. The lower limit is more preferably 60 mol% and the upper limit is more preferably 75 mol%.

The lower limit of the hydroxy group content of the polyvinyl acetal resin is preferably 15 mol% and the upper limit thereof is preferably 35 mol%. When the hydroxy group content is 15 mol% or more, formation of the luminescent sheet is facilitated. When the hydroxy group content is 35 mol% or less, the luminescent sheet to be obtained is easy to handle.

The degree of acetalization and the hydroxy group content can be measured in accordance with, for example, "Testing methods for polyvinyl butyral" in JIS K 6728.

The polyvinyl acetal resin can be prepared by acetalization of polyvinyl alcohol with an aldehyde. The polyvinyl alcohol is normally prepared by saponifying polyvinyl acetate. Polyvinyl alcohol commonly used has a degree of saponification of 70 to 99.8 mol%.

The lower limit of the degree of polymerization of the polyvinyl alcohol is preferably 500 and the upper limit thereof is preferably 4,000. When the polyvinyl alcohol has a degree of polymerization of 500 or more, a laminate produced using the luminescent sheet to be obtained and a transparent plate has higher penetration resistance. When the polyvinyl alcohol has a degree of polymerization of 4,000 or less, formation of the luminescent sheet is facilitated. The lower limit of the degree of polymerization of the polyvinyl alcohol is more preferably 1,000 and the upper limit thereof is more preferably 3,600.

The aldehyde is not particularly limited. Commonly, preferred is a C1-C10 aldehyde. The C1-C10 aldehyde is not particularly limited, and examples thereof include n-butyraldehyde, isobutyraldehyde, n-valeraldehyde, 2-ethylbutyraldehyde, n-hexylaldehyde, n-octylaldehyde, n-nonylaldehyde, n-decylaldehyde, formaldehyde, acetaldehyde, and benzaldehyde. Preferred among these are n-butyraldehyde, n-hexylaldehyde, and n-valeraldehyde, and more preferred is n-butyraldehyde. These aldehydes may be used alone or in combination of two or more thereof.

The luminescent material is a luminescent material that is to be excited by laser light to emit visible light. The use of the luminescent sheet containing such a luminescent material allows easy detection of even non-visible light, that is, ultraviolet laser light or infrared laser light, due to the emission of visible light by the luminescent material upon laser light irradiation. Moreover, part of the energy of the laser light is consumed by the luminescent material to emit light. The energy of the laser light is thus expected to be decreased, reducing damage to the eye.

The luminescent material may be a luminescent material that emits light by visible laser light having a wavelength of 380 to 750 nm, a luminescent material that emits light by ultraviolet laser light having a wavelength of 380 nm or shorter, or a luminescent material that emits light by an infrared laser light having a wavelength of 750 nm or longer, depending on the type of laser light to be detected. These luminescent materials may be used alone or in combination of two or more thereof. Use of two or more luminescent materials in combination allows detection of laser light over a wide wavelength range.

Examples of the luminescent material include a lanthanoid complex with a multidentate ligand containing a halogen atom.

Among lanthanoid complexes, the lanthanoid complex with a multidentate ligand containing a halogen atom emits light at a high intensity by irradiation with laser light. Examples of the lanthanoid complex with a multidentate ligand containing a halogen atom include lanthanoid complexes with a bidentate ligand containing a halogen atom, lanthanoid complexes with a tridentate ligand containing a halogen atom, lanthanoid complexes with a tetradentate ligand containing a halogen atom, lanthanoid complexes with a pentadentate ligand containing a halogen atom, and lanthanoid complexes with a hexadentate ligand containing a halogen atom.

In particular, a lanthanoid complex with a bidentate ligand containing a halogen atom or a lanthanoid complex with a tridentate ligand containing a halogen atom emits light having a wavelength of 580 to 780 nm at a significantly high intensity by irradiation with light having a wavelength of 300 to 410 nm. Owing to such high-intensity luminescence, a luminescent sheet containing the lanthanoid complex can detect laser light irradiation with very high sensitivity. In addition, the lanthanoid complex with a bidentate ligand containing a halogen atom or the lanthanoid complex with a tridentate ligand containing a halogen atom is also excellent in heat resistance. Irradiation with infrared laser light having a wavelength of 750 nm or longer may cause heating of the luminescent material to high temperature to deteriorate the luminescent material. However, the use of a lanthanoid complex with a bidentate ligand containing a halogen atom or a lanthanoid complex with a tridentate ligand containing a halogen atom can prevent deterioration and enables reliable detection of laser light.

As used herein, examples of the lanthanoid include lanthanum, cerium, praseodymium, neodymium, promethium, samarium, europium, gadolinium, terbium, dysprosium, holmium, erbium, thulium, ytterbium, and lutetium. For even higher emission intensity, the lanthanoid is preferably neodymium, europium, or terbium, more preferably europium or terbium, still more preferably europium.

Examples of the lanthanoid complex with a bidentate ligand containing a halogen atom include tris(trifluoroacetylacetone)phenanthroline europium, tris(trifluoroacetylacetone)diphenyl phenanthroline europium, tris(hexafluoroacetylacetone)diphenyl phenanthroline europium, tris(hexafluoroacetylacetone)bis(triphenylphosphine) europium, tris(trifluoroacetylacetone)2,2'-bipyridine europium, and tris(hexafluoroacetylacetone)2,2'-bipyridine europium.

Examples of the lanthanoid complex with a tridentate ligand containing a halogen atom include terpyridine trifluoroacetylacetone europium and terpyridine hexafluoroacetylacetone europium.

Examples of the halogen atom in the lanthanoid complex with a bidentate ligand containing a halogen atom or the lanthanoid complex with a tridentate ligand containing a halogen atom include a fluorine atom, a chlorine atom, a bromine atom, and an iodine atom. Preferred is a fluorine atom for better stability of the ligand structure.

Among the lanthanoid complexes with a bidentate ligand containing a halogen atom and the lanthanoid complexes with a tridentate ligand containing a halogen atom, a lanthanoid complex with a bidentate ligand containing a halogen atom and having an acetylacetone skeleton is preferred because of its excellent initial luminescent properties.

Examples of the lanthanoid complex with a bidentate ligand containing a halogen atom and having an acetylacetone skeleton include Eu(TFA)₃phen, Eu(TFA)₃dpphen, Eu(HFA)₃phen, [Eu(FOD)₃]bpy, [Eu(TFA)₃]tmphen, and [Eu(FOD)₃]phen. The structures of these lanthanoid complexes with a bidentate ligand containing a halogen atom and having an acetylacetone skeleton are shown below.

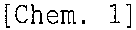

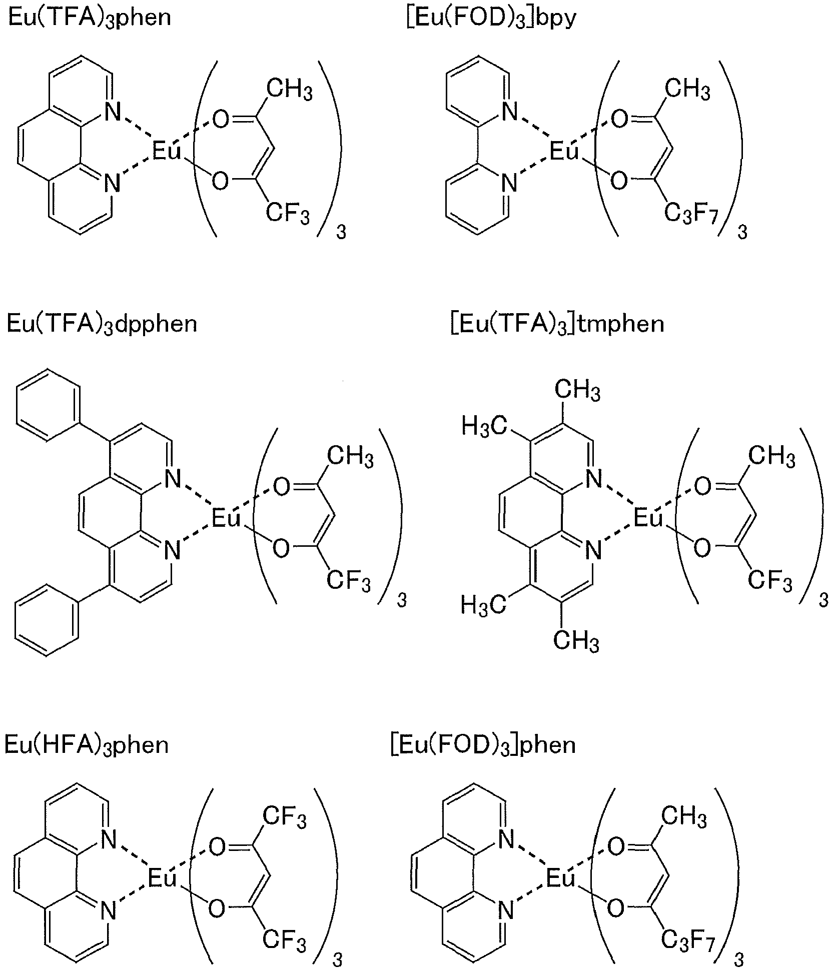

The lanthanoid complex with a bidentate ligand containing a halogen atom or the lanthanoid complex with a tridentate ligand containing a halogen atom is preferably in the form of particles. The lanthanoid complex with a bidentate ligand containing a halogen atom or the lanthanoid complex with a tridentate ligand containing a halogen atom in the form of particles can be readily finely dispersed in the luminescent sheet.

In the case where the lanthanoid complex with a bidentate ligand containing a halogen atom or the lanthanoid complex with a tridentate ligand containing a halogen atom is in the form of particles, the lower limit of the average particle size of the lanthanoid complex is preferably 0.01 µm and the upper limit thereof is preferably 10 µm. The lower limit is more preferably 0.03 µm and the upper limit is more preferably 1 µm.

The luminescent material may be a luminescent material having a terephthalic acid ester structure. The luminescent material having a terephthalic acid ester structure emits light by irradiation with light.

Examples of the luminescent material having a terephthalic acid ester structure include compounds having a structure represented by the formula (1) and compounds having a structure represented by the formula (2).

Each of these may be used alone or in combination of two or more thereof.

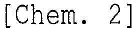

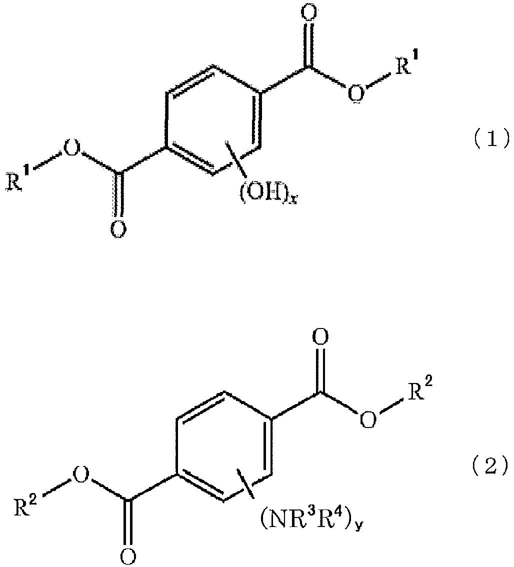

In the formula (1), R¹ is an organic group and x is 1, 2, 3, or 4.

For higher transparency of the luminescent sheet, x is preferably 1 or 2, and the luminescent material has a hydroxy group more preferably at 2 or 5 position of the benzene ring, still more preferably at 2 and 5 positions of the benzene ring.

The organic group of R¹ is preferably a hydrocarbon group, more preferably a C1-C10 hydrocarbon group, still more preferably a C1-C5 hydrocarbon group, particularly preferably a C1-C3 hydrocarbon group.

When the hydrocarbon group has 10 or less carbon atoms, the luminescent material having a terephthalic acid ester structure can be easily dispersed in the luminescent sheet.

The hydrocarbon group is preferably an alkyl group.

Examples of the compound having a structure represented by the formula (1) include diethyl-2,5-dihydroxyterephthalate and dimethyl-2,5-dihydroxyterephthalate.

In particular, for display of an image at higher contrast, the compound having a structure represented by the formula (1) is preferably diethyl-2,5-dihydroxylterephthalate ("diethyl 2,5-dihydroxyterephthalate" available from Sigma-Aldrich).

In the formula (2), R² is an organic group, R³ and R⁴ each are a hydrogen atom or an organic group, and y is 1, 2, 3, or 4.

The organic group of R² is preferably a hydrocarbon group, more preferably a C1-C10 hydrocarbon group, still more preferably a C1-C5 hydrocarbon group, particularly preferably a C1-C3 hydrocarbon group.

When the hydrocarbon group has a carbon number satisfying the upper limit, the luminescent material having a terephthalic acid ester structure can be easily dispersed in the luminescent sheet.

The hydrocarbon group is preferably an alkyl group.

In the formula (2), NR³R⁴ is an amino group.

R³ and R⁴ each are preferably a hydrogen atom.

The benzene ring in the compound having a structure represented by the formula (2) may have the amino group(s) at the position(s) of one hydrogen atom, two hydrogen atoms, three hydrogen atoms, or four hydrogen atoms among hydrogen atoms of the benzene ring.

For display of an image at higher contrast, the compound having a structure represented by the formula (2) is preferably diethyl-2,5-diaminoterephthalate (Sigma-Aldrich).

The amount of the luminescent material in the luminescent sheet may be appropriately adjusted according to the type of the luminescent material. The lower limit of the amount of the luminescent material relative to 100 parts by weight of the thermoplastic resin is preferably 0.001 parts by weight, and the upper limit thereof is preferably 10 parts by weight. When the amount of the luminescent material is 0.001 parts by weight or more, the laser light detecting device can reliably detect laser light irradiation while reducing the irradiation intensity. When the amount of the luminescent material is 10 parts by weight or less, the luminescent sheet has higher transparency. The lower limit of the amount of the luminescent material is more preferably 0.01 parts by weight, and the upper limit thereof is more preferably 8 parts by weight. The lower limit is still more preferably 0.1 parts by weight, and the upper limit is still more preferably 5 parts by weight.

The luminescent sheet may further contain a plasticizer.

Any plasticizer may be used, and examples thereof include organic ester plasticizers such as monobasic organic acid esters and polybasic organic acid esters, and phosphoric acid plasticizers such as organophosphate plasticizers and organophosphite plasticizers. The plasticizer is preferably a liquid plasticizer.

The monobasic organic acid esters are not particularly limited, and examples thereof include glycol esters obtained by a reaction between a glycol and a monobasic organic acid. Examples of the glycol include triethylene glycol, tetraethylene glycol, and tripropylene glycol. Examples of the monobasic organic acid include butyric acid, isobutyric acid, caproic acid, 2-ethylbutyric acid, heptylic acid, n-octylic acid, 2-ethylhexylic acid, pelargonic acid (or n-nonylic acid), and decylic acid. In particular, preferred are triethylene glycol dicaproate, triethylene glycol-di-2-ethylbutyrate, triethylene glycol-di-n-octylate, and triethylene glycol-di-2-ethylhexylate.

The polybasic organic acid esters are not particularly limited, and examples thereof include ester compounds of a polybasic organic acid (e.g., adipic acid, sebacic acid, azelaic acid) with a C4-C8 linear or branched alcohol. In particular, preferred are dibutyl sebacate, dioctyl azelate, and dibutyl carbitol adipate.

The organic ester plasticizers are not particularly limited, and examples thereof include triethylene glycol di-2-ethylbutyrate, triethylene glycol di-2-ethylhexanoate, triethylene glycol dicaprylate, triethylene glycol di-n-octanoate, triethylene glycol di-n-heptanoate, tetraethylene glycol di-n-heptanoate, tetraethylene glycol di-2-ethylhexanoate, dibutyl sebacate, dioctyl azelate, dibutyl carbitol adipate, ethylene glycol di-2-ethylbutyrate, 1,3-propylene glycol di-2-ethylbutyrate, 1,4-butylene glycol di-2-ethylbutyrate, diethylene glycol di-2-ethylbutyrate, diethylene glycol di-2-ethylhexanoate, dipropylene glycol di-2-ethylbutyrate, triethylene glycol di-2-ethylpentanoate, tetraethylene glycol di-2-ethylbutyrate, diethylene glycol dicapriate, dihexyl adipate, dioctyl adipate, hexylcyclohexyl adipate, diisononyl adipate, heptylnonyl adipate, dibutyl sebacate, oil-modified alkyd sebacate, mixtures of phosphoric acid esters and adipic acid esters, adipic acid esters, mixed type adipic acid esters prepared from C4-C9 alkyl alcohols and C4-C9 cyclic alcohols, and C6-C8 adipic acid esters such as hexyl adipate.

The organophosphate plasticizers are not particularly limited, and examples thereof include tributoxyethyl phosphate, isodecylphenyl phosphate, and triisopropyl phosphate.

Among these, the plasticizer is preferably at least one selected from the group consisting of dihexyl adipate (DHA), triethylene glycol di-2-ethylhexanoate (3GO), tetraethylene glycol di-2-ethylhexanoate (4GO), triethylene glycol di-2-ethylbutyrate (3GH), tetraethylene glycol di-2-ethylbutyrate (4GH), tetraethylene glycol di-n-heptanoate (4G7), and triethylene glycol di-n-heptanoate (3G7).

For less hydrolysis, the plasticizer preferably contains triethylene glycol di-2-ethylhexanoate (3GO), triethylene glycol di-2-ethylbutyrate (3GH), tetraethylene glycol di-2-ethylhexanoate (4GO), or dihexyl adipate (DHA), more preferably tetraethylene glycol di-2-ethylhexanoate (4GO) or triethylene glycol di-2-ethylhexanoate (3GO), still more preferably triethylene glycol di-2-ethylhexanoate.

The amount of the plasticizer in the luminescent sheet is not particularly limited. The lower limit thereof is preferably 30 parts by weight and the upper limit thereof is preferably 100 parts by weight relative to 100 parts by weight of the thermoplastic resin. When the amount of the plasticizer is 30 parts by weight or more, the melt viscosity is low, so that the luminescent sheet can be easily formed. When the amount of the plasticizer is 100 parts by weight or less, the luminescent sheet has higher transparency. The lower limit of the amount of the plasticizer is more preferably 35 parts by weight and the upper limit thereof is more preferably 80 parts by weight. The lower limit is still more preferably 45 parts by weight and the upper limit is still more preferably 70 parts by weight. The lower limit is particularly preferably 50 parts by weight and the upper limit is particularly preferably 63 parts by weight.

In the case where the laser light detecting device of the present invention has the laminated glass structure described later, the luminescent sheet preferably contains an adhesion modifier.

The adhesion modifier used is suitably, for example, an alkali metal salt or an alkaline earth metal salt. Examples of the adhesion modifier include salts of potassium, sodium, magnesium, and the like.

Examples of an acid constituting the salts include organic acids such as carboxylic acids (e.g., octylic acid, hexylic acid, 2-ethylbutyric acid, butyric acid, acetic acid, formic acid) and inorganic acids such as hydrochloric acid and nitric acid.

The luminescent sheet can contain, other than the adhesion modifier, potassium, sodium, and magnesium derived from raw materials (e.g., a neutralizing agent) used for production of the thermoplastic resin. When these metals are contained in a large amount, the luminescent properties of the luminescent material may be reduced. Such a reduction in the luminescent properties is particularly noticeable when the luminescent material is a lanthanoid complex with a bidentate ligand containing a halogen atom or a lanthanoid complex with a tridentate ligand containing a halogen atom.

Thus, the total amount of potassium, sodium, and magnesium contained in the luminescent sheet is preferably 50 ppm or less. When the total amount of potassium, sodium, and magnesium is 50 ppm or less, the reduction in the luminescent properties of the luminescent material can be prevented.

The luminescent sheet preferably further contains a dispersant. The presence of a dispersant can inhibit aggregation of the luminescent material.

The dispersant used may be, for example, a compound having a sulfonic acid structure such as linear alkyl benzene sulfonates; a compound having an ester structure such as diester compounds, ricinoleic acid alkyl esters, phthalic acid esters, adipic acid esters, sebacic acid esters, and phosphoric acid esters; a compound having an ether structure such as polyoxyethylene glycols, polyoxypropylene glycols, and alkyl phenyl-polyoxyethylene-ethers; a compound having a carboxylic acid structure such as polycarboxylic acids; a compound having an amine structure such as laurylamine, dimethyllaurylamine, oleyl propylenediamine, polyoxyethylene secondary amine, polyoxyethylene tertiary amine, and polyoxyethylene diamine; a compound having a polyamine structure such as polyalkylene polyamine alkylene oxide; a compound having an amide structure such as oleic acid diethanolamide and alkanol fatty acid amide; and a compound having a high-molecular-weight amide structure such as polyvinylpyrrolidone and polyester acid amidoamine salt. Also, the dispersant used may be a high-molecular-weight dispersant such as polyoxyethylene alkyl ether phosphoric acid (salt), high-molecular-weight polycarboxylic acids, and condensed ricinoleic acid esters. The high-molecular-weight dispersant is defined as a dispersant having a molecular weight of 10,000 or higher.

In the case where the luminescent material is a lanthanoid complex with a bidentate ligand containing a halogen atom or a lanthanoid complex with a tridentate ligand containing a halogen atom, the lower limit of the amount of the dispersant relative to 100 parts by weight of the luminescent material in the luminescent sheet is preferably 1 part by weight and the upper limit thereof is preferably 50 parts by weight. When the amount of the dispersant is within the above range, the lanthanoid complex with a bidentate ligand containing a halogen atom or the lanthanoid complex with a tridentate ligand containing a halogen atom can be uniformly dispersed in the luminescent sheet. The lower limit of the amount of the dispersant is more preferably 3 parts by weight and the upper limit thereof is more preferably 30 parts by weight. The lower limit is still more preferably 5 parts by weight and the upper limit is still more preferably 25 parts by weight.

The luminescent sheet may contain additives such as an ultraviolet absorber, an antioxidant, a light stabilizer, an antistatic agent, a blue pigment, a blue dye, a green pigment, and a green dye, as needed.

The luminescent sheet preferably has a visible light transmittance of 70% or higher. When the visible light transmittance is 70% or higher, the laser light detecting device can be used in various applications such as window glass for vehicles. The visible light transmittance is more preferably 80% or higher, still more preferably 90% or higher.

The lower limit of the luminance of light emitted by the luminescent sheet when the luminescent sheet is irradiated with laser light is preferably 1 cd/m², and the upper limit thereof is preferably 15,000 cd/m². When the luminance is within this range, laser light irradiation can be more reliably detected.

The laser light detecting device of the present invention includes the luminescent sheet, and thus can easily and reliably detect laser light irradiation.

The structure of the laser light detecting device of the present invention is not particularly limited. The laser light detecting device preferably has a laminated structure including a transparent plate and a luminescent sheet. The laser light detecting device having the laminated structure can exhibit improved handleability and thus can be applied to various uses. In particular, the laser light detecting device preferably has a structure (laminated glass structure) in which the luminescent sheet is interposed between a pair of transparent plates.

The transparent plates may be transparent plate glass commonly used. Examples thereof include inorganic glass such as float plate glass, polished plate glass, molded plate glass, wired glass, wire-reinforced plate glass, colored plate glass, heat-absorbing glass, heat-reflecting glass, and green glass. Also usable is UV light-shielding glass in which a UV light-shielding coat layer is formed on the surface of glass. However, such glass is preferably used as a glass plate on a side opposite to the side irradiated with light having a specific wavelength. Moreover, organic plastic plates such as polyethylene terephthalate, polycarbonate, or polyacrylate plates may also be used.

As the transparent plates, two or more kinds of transparent plates may be used. Moreover, as the transparent plates, two or more kinds of transparent plates different in the thickness may be used.

When the laser light detecting device of the present invention has the laminated structure or laminated glass structure and is used as, for example, window glass for a vehicle such as an automobile, a bike, or an airplane, the laser light detecting device can detect laser light irradiation aimed at the driver while reducing the irradiation intensity. The laser light detecting device can also be used as lens of goggles or glasses.

The laser light detecting device of the present invention preferably further includes a detection unit configured to detect laser light irradiation. The presence of such a detection unit enables easier, more reliable detection of laser light irradiation.

The detection unit is not particularly limited, and may be a device that takes an image of the entire surface of the luminescent sheet and transmits a signal when it detects light emission of the luminescent sheet on the obtained image.

The detection unit is preferably a device that detects only laser light irradiation from one side of the laser light detecting device while not detecting laser light irradiation from the other side. In the case where the laser light detecting device of the present invention has the laminated glass structure and is used as, for example, window glass for a vehicle such as an automobile, a bike, or an airplane, such a detection unit allows detection of laser light irradiation from the outside while preventing detection of laser light irradiation from the inside for, for example, display of a head-up display.

The laser light detecting device of the present invention preferably further includes a notification unit configured to provide notification when the detection unit detects a laser. The presence of such a notification unit enables easier and more reliable perception of the detected laser light irradiation.

The notification unit provides notification in response to a signal from the detection unit when the detection unit detects a laser. The method of providing notification is not particularly limited. Examples thereof include sound, vibration, image, and video.

The notification unit is preferably configured to stop providing notification when the detection unit no longer detects laser light. This allows detection of the continuation or discontinuation of laser light irradiation.

### - Advantageous Effects of Invention

The present invention can provide a laser light detecting device capable of easily detecting laser light irradiation.

### DESCRIPTION OF EMBODIMENTS

The present invention is more specifically described in the following with reference to, but not limited to, examples.

### (Example 1)

### (1) Preparation of Eu(TFA)₃phen

Europium acetate (Eu(CH₃COO)₃) in an amount of 12.5 mmol was dissolved in 50 mL of distilled water. To the solution was added 33.6 mmol of trifluoroacetylacetone (TFA, CH₃COCH₂COCF₃), and the mixture was stirred at room temperature for 3 hours. The mixture was filtered to obtain precipitated solid. The precipitated solid was washed with water, and recrystallized using methanol and distilled water to give Eu(TFA)₃(H₂O)₂. Then, 5.77 g of the resulting complex (Eu(TFA)₃(H₂O)₂) and 2.5 g of 1,10-phenanthroline (phen) were dissolved in 100 mL of methanol, followed by heating under reflux for 12 hours. After 12 hours, methanol was distilled off under reduced pressure, thereby obtaining a white product. The white product powder was washed with toluene so that unreacted materials were removed by suction filtration. Subsequently, toluene was distilled off under reduced pressure, thereby preparing a powder. Through recrystallization using a solvent mixture of toluene and hexane, Eu(TFA)₃phen was obtained.

### (2) Preparation of luminescent sheet

To 40 parts by weight of triethylene glycol di-2-ethylhexanoate (3GO) as a plasticizer were added 0.2 parts by weight of Eu(TFA)₃phen as a luminescent material and acetylacetone magnesium at a final concentration of 0.036 phr as an adhesion modifier, whereby a luminescent plasticizer solution was prepared. The entire amount of the plasticizer solution obtained and 100 parts by weight of polyvinyl butyral (PVB, degree of polymerization: 1,700) were sufficiently mixed and kneaded using a mixing roll to prepare a resin composition.

The obtained resin composition was extruded using an extruder to provide a luminescent sheet having a thickness of 760 µm.

### (3) Production of laser light detecting device

The obtained luminescent sheet was interposed between a pair of clear glass plates (thickness: 2.5 mm, 30 cm in length × 30 cm in width) to prepare a laminate. The laminate was pressed under vacuum at 90°C for 30 minutes to be press-bonded using a vacuum laminator. The press-bonded laminate was subjected to further 20-minute press-bonding under 14 MPa at 140°C using an autoclave, thereby obtaining a laser light detecting device having a laminated glass structure.

### (Example 2)

Terbium acetate (Tb(CH₃COO)₃) in an amount of 12.5 mmol was dissolved in 50 mL of distilled water. To the solution was added 33.6 mmol of trifluoroacetylacetone (TFA, CH₃COCH₂COCF₃), and the mixture was stirred at room temperature for 3 hours. The mixture was filtered to obtain precipitated solid. The precipitated solid was washed with water, and recrystallized using methanol and distilled water to give Tb(TFA)₃(H₂O)₂. Then, 5.77 g of the resulting complex (Tb(TFA)₃(H₂O)₂) and 2.5 g of 1,10-phenanthroline (phen) were dissolved in 100 mL of methanol, followed by heating under reflux for 12 hours. After 12 hours, methanol was distilled off under reduced pressure, thereby obtaining a white product. The white product powder was washed with toluene so that unreacted materials were removed by suction filtration. Subsequently, toluene was distilled off under reduced pressure, thereby preparing a powder. Through recrystallization using a solvent mixture of toluene and hexane, Tb(TFA)₃phen was obtained.

A luminescent sheet and a laser light detecting device were produced as in Example 1 except that Tb(TFA)₃phen was used instead of Eu(TFA)₃phen.

### (Example 3)

A luminescent sheet and a laser light detecting device were produced as in Example 1 except that diethyl-2,5-dihydroxyterephthalate (available from Sigma-Aldrich, "diethyl 2,5-dihydroxyterephthalate") was used instead of Eu(TFA)₃phen.

### (Comparative Example 1)

A luminescent sheet and a laser light detecting device were produced as in Example 1 except that no luminescent material was used.

### (Evaluation)

The laser light detecting devices obtained in the examples and comparative example were evaluated for the laser detectability by the following methods.

Table 1 shows the results.

### (Laser detectability: direct observation)

A laser light source, the laser light detecting device, and an observer were placed in a straight line in the stated order such that the distance between the laser light source and the laser light detecting device in the horizontal direction was 20 m and the distance between the laser light detecting device and the observer in the horizontal direction was 1 m. The heights of the laser light source and the laser light detecting device were adjusted to the eye level of the observer.

Under these conditions, laser light was applied from the laser light source such that the laser light did not directly enter the observer's eyes (aimed at the forehead). A rating of "o (Good)" was given when the observer detected the laser light irradiation by light emission on the laser light detecting device. A rating of "× (Poor)" was given when the observer did not detect the irradiation.

The laser light source used was "NDV4B16" (wavelength: 405 nm, output power: 300 mW) available from Nichia Corporation. The position of laser light was recorded to apply laser light to the same position in the following indirect evaluation and evaluation of notification by sound.

### (Laser detectability: indirect observation)

A laser light source, the laser light detecting device, and an observer were placed as in the direct observation except that the distance between the laser light detecting device and the observer was 1 m and the observer was placed at an angle of 45° in the horizontal direction relative to the center part of the glass of the laser light detecting device. The heights of the laser light source and the laser light detecting device were adjusted to the eye level of the observer. Under these conditions, laser light was applied from the laser light source to the same position as in the direct observation. A rating of "o (Good)" was given when the observer detected the laser light irradiation by light emission on the laser light detecting device. A rating of "x (Poor)" was given when the observer did not detect the irradiation.

With the laser light detecting devices obtained in Examples 1 to 3, the observer detected the laser light even when the observer was not in the straight line of the laser light.

### (Laser detectability: notification of laser light irradiation by sound)

A laser light source, the laser light detecting device, and a detection unit were placed such that the distance between the laser source and the laser light detecting device in the horizontal direction was 20 m and the distance between the laser light detecting device and the detection unit in the horizontal direction was 1 m. The detection unit was placed at an angle of 45° in the horizontal direction relative to the center of the glass of the laser light detecting device. The detection unit used was a device that takes an image of the entire surface of the laser light detecting device (luminescent sheet) and transmits a signal to the notification unit when it detects light emission of the laser light detecting device (luminescent sheet) on the obtained image. There was also provided a notification unit that provides notification by sound in response to a signal from the detection unit when the detection unit detects a laser.

Under these conditions, laser light was applied from the laser light source to the same position as in the direct observation performed earlier. A rating of "o (Good)" was given when the laser light irradiation was detected by the sound of the notification unit. A rating of "× (Poor)" was given when the irradiation was not detected.

With the laser light detecting devices obtained in Examples 1 to 3, the observer detected the laser light by the sound emitted by the notification unit.

**[Table 1]**

| | | | | Example 1 | Example 2 | Example 3 | Comparative Example 1 |
|---|---|---|---|---|---|---|---|
| Luminescent sheet formulation | PVB | | phr | 100 | 100 | 100 | 100 |
| | 3GO | | phr | 40 | 40 | 40 | 40 |
| | Luminescent material | Eu(TFA)₃phen | phr | 0.2 | - | - | - |
| | | Tb(TFA)₃phen | phr | - | 0.2 | - | - |
| | | Diethyl 2,5-dihydroxyterephthalate | phr | - | - | 0.2 | - |
| | Adhesion modifier | Acetylacetone magnesium | phr | 0.036 | 0.036 | 0.036 | 0.036 |
| Evaluation | Laser detectability (direct observation) | | - | ○ | ○ | ○ | ○ |
| | Laser detectability (indirect observation) | | - | ○ | ○ | ○ | × |
| | Laser detectability (notification by sound) | | - | ○ | ○ | ○ | × |

### INDUSTRIAL APPLICABILITY

The present invention can provide a laser light detecting device capable of easily detecting laser light irradiation.

## Claims

1. A laser light detecting device capable of detecting laser light irradiation, comprising
a luminescent sheet containing a thermoplastic resin and a luminescent material that is to be excited by laser light to emit visible light.

2. The laser light detecting device according to claim 1,
wherein the luminescent material emits light by visible laser light having a wavelength of 380 to 750 nm.

3. The laser light detecting device according to claim 1,
wherein the luminescent material emits light by ultraviolet laser light having a wavelength of 380 nm or shorter.

4. The laser light detecting device according to claim 1,
wherein the luminescent material emits light by infrared laser light having a wavelength of 750 nm or longer.

5. The laser light detecting device according to claim 1, 2, 3, or 4, which has a laminated structure including a transparent plate and the luminescent sheet.

6. The laser light detecting device according to claim 1, 2, 3, or 4, which has a structure in which the luminescent sheet is interposed between a pair of transparent plates.

7. The laser light detecting device according to claim 1, 2, 3, 4, 5, or 6, further comprising a detection unit configured to detect laser light irradiation.

8. The laser light detecting device according to claim 7, further comprising a notification unit configured to provide notification when the detection unit detects a laser.

9. The laser light detecting device according to claim 8,
wherein the notification unit is configured to stop providing notification when the detection unit no longer detects laser light.
